(19) Europäisches Patentamt
European Patent Office
Office européen des brevets

(11) Veröffentlichungsnummer: **0 394 738 A2**

(12) # EUROPÄISCHE PATENTANMELDUNG

(21) Anmeldenummer: **90106829.6**

(51) Int. Cl.5: **G03F 7/095, G03F 7/20**

(22) Anmeldetag: **10.04.90**

(30) Priorität: **24.04.89 DE 3913467**

(43) Veröffentlichungstag der Anmeldung:
**31.10.90 Patentblatt 90/44**

(84) Benannte Vertragsstaaten:
**BE CH DE ES FR GB IT LI NL SE**

(71) Anmelder: **Siemens Aktiengesellschaft**
**Wittelsbacherplatz 2**
**D-8000 München 2(DE)**

(72) Erfinder: **Sezi, Recai, Dr.-Ing.**
**Weiherstrasse 14**
**D-8551 Röttenbach(DE)**
Erfinder: **Leuschner, Rainer, Dr. rer. nat.**
**Buchenweg 2**
**D-8521 Grossenseebach(DE)**
Erfinder: **Sebald, Michael, Dr. rer. nat.**
**Kirchensteig 3**
**D-8521 Hessdorf(DE)**
Erfinder: **Birkle, Siegfried, Dr. rer. nat.**
**Veit-Stoss-Strasse 46**
**D-8552 Höchstadt(DE)**
Erfinder: **Ahne, Hellmut, Dr.**
**Heideweg 7**
**D-8551 Röttenbach(DE)**

(54) **Vereinfachtes Mehrlagenphotoresistsystem.**

(57) Zur Erzeugung einer hochaufgelösten Photoresiststruktur wird ein vereinfachtes Mehrlagensystem vorgeschlagen, bei dem in einer Photolackschicht durch eine erste strukturierende Belichtung mit niedriger Lichtintensität und eine darauf folgende chemische Behandlung eine interne Maske für eine zweite Flutbelichtung gebildet wird. In den zuerst belichteten Bereichen wird durch Behandlung mit einem UV-Lichtabsorber eine Lichtundurchlässigkeit für die zweite Belichtung erreicht, während durch Behandlung mit einer mehrfunktionellen Komponente eine Vernetzung des Basispolymeren erreicht wird, die diese Bereiche gegenüber den im abschließenden Entwicklungsschritt eingesetzten Entwickler unlöslich macht. Das insgesamt einfach durchzuführende Verfahren erlaubt die Herstellung hochaufgelöster Photolackstrukturen mit senkrechten Flanken und hohem Aspektverhältnis.

FIG 3

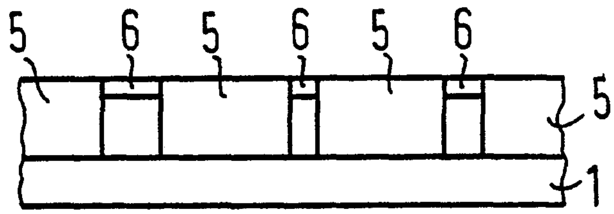


EP 0 394 738 A2

## Vereinfachtes Mehrlagenphotoresistsystem.

Die Erfindung betrifft ein Verfahren zum Erzeugen einer hochaufgelösten Resiststruktur.

Die Produktion höchstintegrierter Bauelemente in der Mikroelektronik stellt zunehmende Anforderungen an Photoresistsysteme. Durch stetige Steigerung der Integrationsdichte bei integrierten Schaltungen müssen auch die auf bzw. in den Schaltungen enthaltenen Strukturen stetig verkleinert werden. Dazu sind entsprechende Photoresistsysteme erforderlich. Neben der Verwendung von Bestrahlungsquellen, wie zum Beispiel Röntgenstrahlen oder Elektronenstrahlen, wird bei einer Photostrukturierung mit Licht eine möglichst kurze Wellenlänge angestrebt. Gängige Lichtquellen zeigen im kurzwelligen Bereich jedoch eine im Vergleich zur verbrauchten Energie geringe Lichtausbeute. Um bei der Photostrukturierung trotzdem einen gleichbleibenden Durchsatz bei entsprechend hoher Qualität zu erhalten, müssen die Photoresists in ihrer Empfindlichkeit verbessert werden. Da die Verkleinerung der vertikalen Strukturdimensionen nicht mit der Verminderung der lateralen Strukturdimensionen Schritt hält, treten als weiteres Problem höhere Aspektverhältnisse auf. Das heißt, daß zum Beispiel das Verhältnis von Tiefe zu Breite eines Grabens einen so hohen Wert annimmt, daß ein derartiger Graben nahezu senkrechte Flanken aufweisen muß. Daher müssen auch Entwicklungsfähigkeit, Auflösung und Kontrast der Photoresists verbessert werden.

Dient ein Photoresist zur Strukturierung eines Substrates mit ebener Oberfläche, so genügt es bei ausreichender Ätzresistenz des Photoresists, diesen in einer so dünnen Schicht aufzubringen, deren Dicke geringer ist als die Fokustiefe der Belichtungsstrahlung. Diese mit der Wellenlänge des zur Belichtung verwendeten Lichts kleiner werdende Fokustiefe bezeichnet den Entfernungsspielraum zu der zur Abbildung verwendeten Optik, innerhalb der aus physikalischen Gründen eine gute Auflösung erziehlt werden kann.

Schwierigkeiten treten dann auf, wenn über einer unebenen Substratoberfläche oder über Substratstufen die Schichtdicke eines Photoresistfilms notgedrungen zunehmen muß. Neben der mangelnden Fokustoleranz treten dort zusätzliche Unschärfen durch Reflexionen an den Kanten von Substratstufen auf. Dieses Streulicht führt zu ungewollter Belichtung von benachbarten Bereichen der Resistschicht. Man erhält eine schlechtere Auflösung und einen schlechteren Kontrast.

In der sogenannten Zweilagentechnik wird ein Substrat mit unebener Oberfläche zunächst mit einer planarisierenden Hilfsschicht aus einem optisch dichten filmbildenden Resist versehen. Darüber wird eine dünne Schicht eines normal photostrukturierbaren Resists aufgebracht und ganz normale strukturiert. In einem zusätzlichen Arbeitsschritt wird die Struktur der oberen Photoresistschicht durch ein anisotropes Ätzverfahren auf die darunterliegende Hilfsschicht übertragen. Dadurch können zwar hochaufgelöste Resiststrukturen erzeugt werden, doch ist das Verfahren technisch aufwendiger und erfordert außerdem einen höheren Kosten- und Zeitaufwand als entsprechende Einlagen - Resistsysteme.

Mit einer Zwischenform von Ein- und Zweilagentechnik wird versucht, die Eigenschaften von Zweilagenresistsystemen durch besondere Maßnahmen auf Einlagenresists zu übertragen. In einem Artikel von F. A. Vollenbroek et al in der Zeitschrift Microel. Engin. 6, Seite 495 (1987) wird zum Beispiel ein solches als built in mask (= bim) bezeichnetes System beschrieben. Hierbei wird einem kommerziellen Positivresist auf Novolak/Chinonazid-Basis ein Triazin beigemischt, welches nach strukturierender Belichtung und nachfolgender Temperaturbehandlung einen stark absorbierenden Azofarbstoff erzeugt. Durch anschließende Flutbelichtung und Entwicklung wird ein negatives Bild erhalten. Nachteilig an diesem System ist jedoch, daß bei der Temperaturbehandlung die Löslichkeit der im ersten Schritt unbelichteten Bereiche herabgesetzt wird, so daß diese schwer entwickel bar sind. Auch die Absorptionszunahme durch den entstandenen Farbstoff erfolgt nicht in einem solchen Umfang, daß eine optimale Auflösung erreicht wird. Dies wird auf unkontrollierte Nebenreaktionen zurückgeführt.

Ein weiteres Einlagenresistsystem, welches in seinen Eigenschaften einem Mehrlagensystem angenähert ist, ist in der europäischen Patentanmeldung EP-A-0 251 241 beschrieben. Hierbei wird ein Resist, welcher aus Poly(t-Butoxy-Carbonyloxystyrol) und einem Säurebildner besteht mit sehr geringer Intensität im tiefen UV-Bereich belichtet. Die Energie der Belichtung ist gerade ausreichend, um in den obersten Schichtbereichen des Photoresists eine Photoreaktion zu erzeugen. Nach einer Temperaturbehandlung wird der Resist im Vakuum bei erhöhter Temperatur mit einem Amin und Phenylisocyanat behandelt. Nach der Entfernung von Phenylisocyanat und dem Amin wird der Resist unter reduziertem Druck erneut für mehrere Minuten auf ca. 130 bis 135 °C erwärmt, um nicht reagiertes Amin oderIsocyanat zu entfernen. In den belichteten Bereichen ist somit ein Urethan entstanden, welches stark im tiefen UV-Bereich (240 bis 260 nm) absorbiert und bei einer anschließenden Flutbelichtung (bei 254 nm) als Kontaktmaske fungiert. Nach erneuter Wärmebehandlung und Entwicklung werden negative Muster enthalten. Dieses Verfahren erfordert eine Vielzahl zusätzlicher Schritte, die unter anderem wegen des nötigen Vakuums kompliziert sind und einen hohen Zeitaufwand erfordern. Außerdem ist der Umgang mit dem hydrolyseempfindlichen und

giftigen Phenylisocyanat nur unter besonderen Vorsichtsmaßnahmen möglich.

Aufgabe der vorliegenden Erfindung ist es daher, ein Verfahren zum Erzeugen einer hochaufgelösten Resiststruktur anzugeben, welches eine verbesserte Einlagentechnik darstellt, auf gängigen und einfachen Vorrichtungen durchzuführen ist und außerdem die aufgeführten Nachteile der bekannten "vereinfachten" Mehrlagensysteme vermeidet.

Diese Aufgabe wird durch ein Verfahren gelöst, welches erfindungsgemäß die Merkmale des Patentanspruchs 1 aufweist. Weitere Ausgestaltungen der Erfindung sind den Unteransprüchen zu ent nehmen.

Das erfindungsgemäße Verfahren weist gegenüber der Einlagentechnik lediglich zwei weitere Schritte auf. Diese beinhalten einfache Maßnahmen, die auf vorhandenen Vorrichtungen problemlos durchzuführen sind. So kann die Behandlung im Verfahrensschritt c) bei Raumtemperatur und auch bei Normaldruck durchgeführt werden. Das Agens kann in wäßriger Phase eingesetzt werden und ist somit nicht hydrolyseempfindlich. Daher kann der Schritt c) auch in einem offenen System durchgeführt werden. Außerdem ist die Dauer der strukturierenden Belichtung (Verfahrensschritt b)) deutlich gegenüber dem Einlagenverfahren verkürzt. Da die strukturierende Belichtung üblicherweise in einem kostenintensiven Waferstepper durchgeführt wird, verkürzen sich auch dessen Belegungszeiten. Diese Belichtung wird für jeden Wafer einzeln durchgeführt und trägt daher nicht unerheblich zur gesamten Verfahrensdauer bei. Die Flutbelichtung hingegen ist technisch weniger aufwendig als eine strukturierende Belichtung und bringt daher eine zusätzliche Zeit- und Kostenersparnis. Durch die Behandlung mit einer mehrfunktionellen Komponente im Verfahrensschritt c) wird die Photolackschicht in den belichteten Bereichen vernetzt und somit gegenüber dem Entwicklungsverfahren (Verfahrensschritt f) unlöslich. Dadurch wird der erzielbare Kontrast des gesamten erfindungsgemäßen Verfahrens verbessert, da sowohl Unlöslichkeit in den zunächst belichteten Bereichen als auch verbesserte Löslichkeit (durch die Flutbelichtung) in den übrigen Bereichen erzeugt wird. So werden die steilen Flanken der erzeugten Resiststruktur ermöglicht, die wie bereits erwähnt, die Voraussetzung für ein größeres Aspektverhältnis und somit eine höhere Integrationsdichte sind.

Das in Schritt c) verwendete Agens kann eine Lösung oder Emulsion sein, wobei das Lösungsmittel zumindest Wasser enthält und die anderen Lösungsmittelkomponenten mit Wasser mischbar sind. Doch auch Wasser allein ist möglich. Vorteilhafterweise stellt das Agens jedoch eine wäßrig-alkoholische Lösung dar. Der Umgang mit dieser kann dabei im offenen system erfolgen. Es ist also keine Schutzgasatmosphäre erforderlich, da das Agens bezüglich des Luftsauerstoffs und der Luftfeuchtigkeit unempfindlich ist. Bei Raumtemperatur und Normaldruck kann die Behandlung daher in einem üblichen Sprüh-, Puddle-oder Tauchentwickler durchgeführt werden. Dies sind einfache Apparaturen, die bei einer Behandlungsdauer von maximal einigen Minuten einen hohen Durchsatz an zu behandelnden Wafern bzw. Substraten erlauben.

Die Spezifität der Behandlung gemäß Verfahrensschritt c) beruht auf dem durch die Belichtung hervorgerufenen Polaritätswechsel. Dieser beruht auf einer chemischen Veränderung der photoaktiven Komponente, die zusammen mit einem nahezu beliebigen Basispolymer den Positivphotolack bildet. Im Urzustand sind sowohl Basispolymer als auch photoaktive Komponente hydrophob und verhindern so den Angriff einer polaren Lösung oder Emulsion, insbesondere auf wäßriger Basis, in der Agens oder Entwickler vorliegen. Bei der Belichtung erfährt die photoaktive Komponente eine photochemische Veränderung, in deren Folge polare Gruppen entstehen, die die photoaktive Komponente hydrophil machen. Diese Eigenschaft wird dabei auf die gesamte Photolackschicht bzw. deren belichtete Bereiche übertragen. So ist es dem UV-Lichtabsorber möglich, in diese hydrophilen Bereiche einzudiffundieren. Vorteilhafterweise weist diese Komponente zumindest eine reaktive Gruppe auf, die sie zu einer chemischen Anbindung an eine Komponente des Photolacks befähigt. In einer weiteren Ausgestaltung der Erfindung weist der UV-Lichtabsorber mindestens zwei reaktive Gruppen auf, die ihn zu einer Vernetzung des im Photolack enthaltenen Basispolymers befähigen. Somit sind sowohl UV-absorbierende als auch vernetzende Komponenten in einer einzigen Verbindung realisiert. Die Anbindung einzelner Komponenten erfolgt dabei vorzugsweise an das Basispolymer, kann aber auch an die photoaktive Komponente vorgenommen werden. Voraussetzung dafür ist jedoch, daß im Photolack nach der Belichtung reaktive Gruppen vorhanden sind, die eine Anbindung weiterer Komponenten gestatten.

Die Auswahl der reaktiven Gruppen an der oder den Komponenten des Agens ist selbstverständlich von der Auswahl des Photolacks abhängig, während die Auswahl des UV-Lichtabsorbers, des Ba sispolymers und der photoaktiven Komponente von der Wellenlänge des zur Belichtung verwendeten Lichts eingeschränkt wird. Das Basispolymer muß gegenüber der Belichtung hinreichend transparent sein. Insbesondere für kürzerwelliges Licht, z.B. tiefes UV-Licht von 240 bis 280 nm, ist dies von Bedeutung , da die meisten Polymere in diesem Bereich eine erhöhte Absorption zeigen. Die photoaktive Komponente muß mit der Wellenlänge des zur Belichtung verwendeten Lichts korrelieren und gut ausbleichen. Das heißt, daß deren Absorption während der Belichtung auf einen möglichst niedrigen Wert abnimmt. Der UV-Lichtabsorber dagegen soll für eben dieses Licht eine hohe Absorption zeigen, um nach der chemischen Anbindung in

den zuerst belichteten Bereichen während der Flutbelichtung tieferliegende Schichtbereiche vollständig abzuschatten.

Um die durch physikalische Gesetzmäßigkeiten vorgegebene Auflösungsgrenze von photolithographischen Verfahren weiter zu steigern, ist bei der Belichtung ein Übergang zu Licht im tiefen UV-Bereich nötig. Hinreichend transparent für tiefes UV-Licht von 240 nm und mehr sind zum Beispiel Polymere und Copolymere Anhydrid- und/oder Epoxidmonomeren. Bevorzugte Basispolymere für den im erfindungsgemäßen Verfahren verwendeten Positivphotolack enthalten also deren Funktionen als reaktive Gruppen. Die Anhydridfunktionen können dabei cyclisch oder linear sein und sowohl in der Haupt- als auch in einer Seitenketten des Basispolymeren enthalten sein.

Gut zugänglich sind Basispolymere, die durch Polymerisation oder Copolymerisation von olefinisch ungesättigten cyclischen Carbonsäureanhydriden erhalten werden. Beispiele für solche Monomere stellen die im folgenden angegebenen Strukturen A,B,C oder D dar,

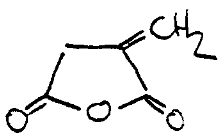
A

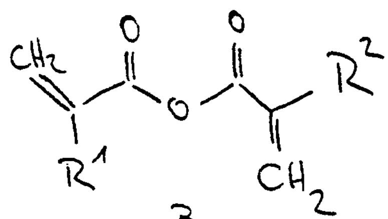
B

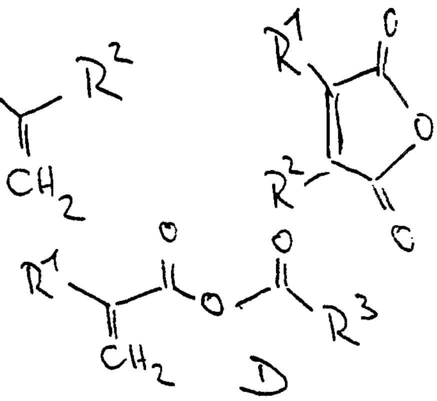
C

D

wobei die Reste $R^1$ und $R^2$ für H oder Alkyl stehen und $R^3$ einen Alkyl oder Arylrest darstellt. Auch Copolymerisation mit anderen Monomeren ist möglich, wobei jedoch der Anteil des Anhydridfunktionen tragenden Monomers zwischen 1 und 100 Prozent eingestellt wird.

Vorteilhaft und gut zugänglich ist ein Basispolymer, das zu 10 bis 55 Mol-Prozent aus Maleinsäureanhydridmonomeren abgeleitet ist und beispielsweise als Copolymer mit Styrol eingesetzt wird.

Geeignete photoaktive Komponenten sind in ausreichender Anzahl bekannt. Gut geeignet sind Chinondiazide, die zum Beispiel einer der angegebenen Strukturformeln F, G oder H gehorchen oder von dieser abgeleitet sind,

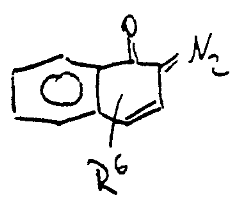
F

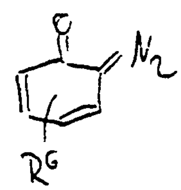
G

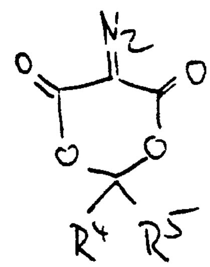
H

wobei $R^3$ und $R^4$ unabhängig voneinander für einen beliebigen organischen Rest stehen, $R^6$-$SO_3R$ oder $CO_2R$ bedeuten kann, und R für Alkyl, Aryl, Halogenalkyl, Halogenaryl oder Halogen steht. Die vollständige

chemische Struktur einer photoaktiven Komponente ist dabei auf das verwendete entsprechende Basispolymer abgestimmt. Ausgehend zum Beispiel von den mit reaktiven Carbonsäure- bzw. Sulfonsäurederivaten substituierten Chinondiaziden sind deren Umsetzungsprodukte mit aromatischen oder aliphatischen Haciden Verbindungen wie Alkoholen, Phenolen und Aminen bevorzugt. Gut geeignet in Verbindung mit maleinsäurehaltigen Basispolymeren ist der 4 Sulfonsäureester von Naphthochinondiazid mit mehrwertigen Phenolen, beispielsweise mit Bisphenol A. Ein auf einen derartigen Photolack abgestimmtes Agens weist bevorzugt Komponenten auf, welche als reaktive Gruppen primäre oder sekundäre Aminofunktionen tragen. Für die mehrfunktionelle Komponente sind neben der Aminogruppe auch OH-Gruppen geeignet. Durch Angriff einer Aminogruppe wird zum Beispiel der Ring einer cyclischen Anhydridgruppe geöffnet, wobei gemäß der Gleichung

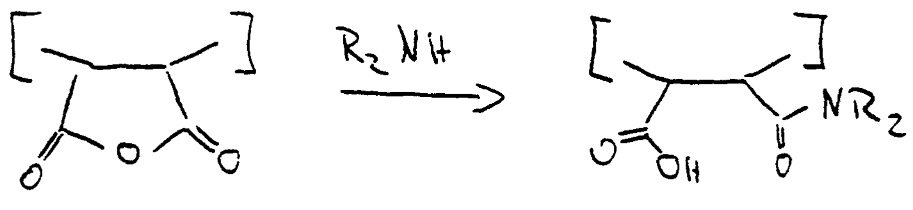


eine Amidocarbonsäure gebildet wird, die ihrerseits nun mit weiteren funktionellen Gruppen zu reagieren vermag.

In einer Ausführungsform der Erfindung enthält das Agens zumindest eine Komponente, welche einer der folgenden allgemeinen Strukturen K,L oder M gehorcht

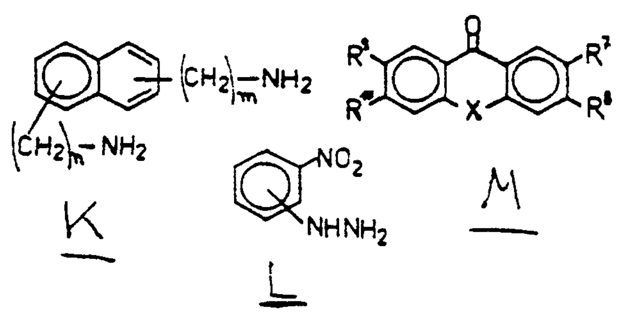

K L M

wobei m und n ganze Zahlen mit 0 m,n 10 darstellen, R7 und R8 für H oder eine elektronenzielende Gruppe wie $-NO_2$ oder -COOR stehen, $R^8$ und $R^{10}$ $(CH_2)m$ - $NH_2$ bedeuten und X für -S-, -NH-, $CH_2$-, oder -O- steht.

Neben der bevorzugten Verwendung des Agens in flüssiger Phase kann im Rahmen der angegebenen chemischen Parameter auch eine Gasphasenbehandlung gegebenenfalls bei erhöhter Temperatur, durchgeführt werden.

Im folgenden wird für ein Ausführungsbeispiel die Zusammensetzung eines Positivphotolackes und eines für diesen Photo lack geeigneten Agens angegeben und deren Verwendung in einem Ausführungsbeispiel und den dazugehörigen vier Figuren näher erläutert. Die Figuren zeigen im schematischen Querschnitt einzelne Verfahrensstufen bei der Herstellung einer Photoresiststruktur auf einem Substrat gemäß der Lehre der Erfindung.

Photolackzusammensetzung:

Ein zur Durchführung des erfindungsgemäßen Verfahrens geeigneter Positivphotolack enthält zum Beispiel 16 Gewichtsteile eines Basispolymeren, welches ein Copolymer aus Styrol und Maleinsäureanhydrid ist und durch radikalische Polymerisation der beiden Monomeren erhalten wird. Als photoaktive Komponente wird der Diester des Bisphenol A mit Naphthochinondiazid-4-sulfonsäure gewählt und davon 4 Gewichtsteile zusammen mit dem Basispolymer in 80 Gewichtsteilen 2-Methoxy-1-propylacetat gelöst.

Zusammensetzung des Agens:

Eine geeignete Lösung für einen UV-Lichtabsorber/Vernetzer besteht aus 4 Gewichtsteilen 1-Naphthylamin, 76 Gewichtsteilen Isopropylalkohol, 0,8 Gewichtsteilen 3-(Aminomethyl) benzylamin, 1,2 Gewichtsteilen Triethylamin und 18 Gewichtsteilen Wasser. Anstelle von 1-Naphthylamin können auch andere Absorber, wie zum Beispiel 4-Nitrophenylhydrazin usw. , jedoch in anderen Konzentrationsverhältnissen verwendet werden.

Ausführungsbeispiel:

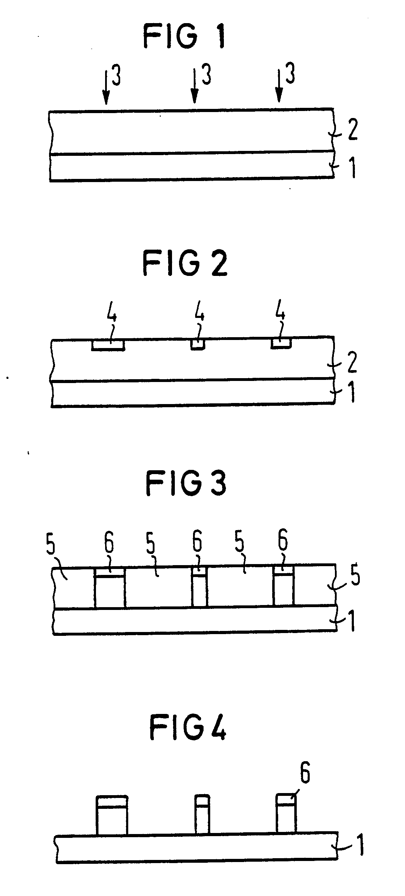

Figur 1: Auf einem drei Zoll Siliziumwafer 1wird die oben angegebene Photolacklösung aufgeschleudert. Nach Trocknung bei 110° auf der Hotplate beträgt die Schichtdicke des Photolacks 2 1,0 µm. Durch eine Maske wird der so beschichtete Wafer nun mit 20 bis 30 $mJ/cm^2$ und einer Wellenlänge von 249 nm kontaktbelichtet (siehe Pfeile 3).

Figur 2 zeigt die Anordnung nach der Kontaktbelichtung. Durch photochemische Reaktion der photoaktiven Komponente sind die belichteten Bereiche 4 in der Photolackschicht 2 hydrophiliert. Bei der anschließenden ca. 6 minütigen Behandlung mit einem Agens (siehe angegebene Lösung) können nun die polaren Komponenten des Agens, der UV-Lichtabsorber und der Vernetzer in diese Bereiche 4 der Photolackschicht 2 eindiffundieren und aufgrund ihrer reaktiven Gruppen mit dem Basispolymer des Photolacks reagieren. Das substituierte Benzylamin, welches zwei reaktive Aminogruppen aufweist, bewirkt dabei eine Vernetzung der Basispolymeren des Positivphotolacks in den belichteten Bereichen 4, in denen sich auch der UV-Lichtabsorber über seine reaktive Gruppe an das Basispolymer chemisch anbindet. Zur Entfernung des restlichen Agens wird der Wafer mit Isopropanol gespült und für kurze Zeit erneut bei 110° C getrocknet. Anschließend wird die Photolackschicht 2 erneut im Wellenlängenbereich von etwa 240 bis 250 nm mit einer Dosis von 160 $mJ/cm^2$ flutbelichtet.

Figur 3: Die aus den belichteten Bereichen 4 hervorgegangenen, mit UV-Lichtabsorber und Vernetzer behandelten oberflächennahen Bereiche 6 der Photolackschicht 2 bewirken bei der Flutbelichtung eine Abschattung der darunter liegenden Teile der Photolackschicht 2 gegen die zur Flutbelichtung verwendete Strahlung. Lediglich in den benachbarten, nicht von den Bereichen 6 abgedeckten Zonen 5 der Photolackschicht 2 hat bei der Flutbelichtung eine chemische Reaktion der photoaktiven Komponente stattgefunden. Diese Zonen 5 werden im nun folgenden Entwicklungsvorgang einem Angriff des Entwicklers zugänglich. Dazu wird ein Gewichtsteil des käuflichen Entwicklers AZ 400 K (Firma Hoechst) mit fünf Teilen Wasser verdünnt und mit 0,5 Gewichtsteilen Ammoniak versetzt.

In Figur 4 sind die so erzeugten Photolackstrukturen dargestellt. Die Vernetzung des Basispolymers in den Bereichen 6 verhindert einen Angriff des Entwicklers auf diese, während die darunterliegenden Schichtteile nicht belichtet und da her hydrophob sind. Lediglich im Bereich der Zonen 5 wird der belichtete Photolack durch den Entwickler entfernt. Die entstehenden Strukturen weisen senkrechte Flanken auf.

Mit diesem willkürlich herausgegriffenen Ausführungsbeispiel, das nur eine von vielen Möglichkeiten zur Durchführung des erfindungsgemäßen Verfahrens darstellt, werden die Vorteile dieses Verfahrens deutlich. Zur Erzeugung hochaufgelöster Photoresiststrukturen, die mit einem hohen Aspektverhältnis dargestellt werden können, ist nur noch eine Photolackschicht erforderlich. Mittels einfacher Verfahrensschritte wird in oberflächennahen Bereichen eine durch die erste Belichtung definierte und durch die Behandlung mit dem Agens ausgebildete chemische Struktur erzeugt, die als Kontaktmaske für den zweiten Belichtungsschritt dient. Damit ist es möglich, auch in dickeren Photolackschichten als bei der Einlagentechnik eine gute Auflösung zu erzielen. Mit den vorgeschlagenen oder im Ausführungsbeispiel genau definierten Photolack- und Agens-Zusammensetzungen ist eine Strukturierung mit tiefem UV-Licht denkbar und ermöglicht so die Erzeugung von Photoresiststrukturen im Halb-µm-Bereich.

**Ansprüche**

1. Verfahren zur Erzeugung einer hochaufgelösten einlagigen Resiststruktur auf einem Substrat, bei dem

a) auf dem Substrat 1 eine Schicht 2 eines Positivphotolacks aufgebracht wird, welcher ein für UV-Licht hinreichend transparentes Basispolymer und eine gut bleichende photoaktive Komponente aufweist

b) die Photolackschicht 2 bildhaft strukturierend belichtet wird, wobei die Energie so gering gewählt wird, daß ein Polaritätswechsel bei den belichteten Flächen nur in den oberflächennahen Schichtbereichen

4 bewirkt wird,

c) die belichtete Schicht mit einem Agens behandelt wird, welches zumindest eine Komponente enthält, die spezifisch in die belichteten oberflächennahen Bereiche 4 einzudringen vermag und ein UV-Lichtabsorber ist, und wobei diese oder eine weitere enthaltene Komponente mehrfunktionell ist und eine Vernetzung der Photolackschicht in den belichteten Bereichen bewirkt,

d) das Substrat bzw. die Photolackschicht 2 gegebenenfalls gespült und getrocknet wird,

e) eine ganzflächige UV-Flutbelichtung durchgeführt wird, wobei die bereits vorher belichteten Bereiche mit der UV-absorbierenden Komponente als Kontaktmaske 6 dienen und die unter dieser Maske liegenden Schichtteile vor der Flutbelichtung schützen und bei dem schließlich

f) die Schicht in üblicher Weise entwickelt wird, wobei eine Resiststruktur mit steilen Flanken erhalten wird, die ein negatives Bild darstellt.

2. Verfahren nach Anspruch 1,**dadurch gekennzeichnet,** daß das Agens in wäßriger oder zumindest Wasser enthaltender Lösung oder Emulsion eingesetzt wird.

3. Verfahren nach Anspruch 2, **dadurch gekennzeichnet,** daß das Agens eine wäßrig-alkoholische Lösung ist.

4. Verfahren nach mindestens einem der Ansprüche 1 bis 3, **dadurch gekennzeichnet,** daß die Behandlung der Schicht 2 mit dem Agens unter bezüglich Atmosphäre und Druck normalen Bedingungen durchgeführt wird.

5. Verfahren nach mindestens einem der Ansprüche 1 bis 4, **dadurch gekennzeichnet,** daß die Behandlung gemäß Verfahrensschritt c) in einem Sprüh-, Puddle- oder Tauchentwickler erfolgt.

6. Verfahren nach mindestens einem der Ansprüche 1 bis 5, **dadurch gekennzeichnet,** daß die Behandlung bei Raumtemperatur durchgeführt wird.

7. Verfahren nach mindestens einem der Ansprüche 1 bis 6, **dadurch gekennzeichnet,** daß das Basispolymer des Positiv-Photolacks reaktive Gruppen enthält, welche ausgewählt sind aus Anhydrid und/oder Epoxid.

8. Verfahren nach Anspruch 7, **dadurch gekennzeichnet,** daß das Basispolymer ein Copolymer von Maleinsäureanhydrid und Styrol ist.

9. Verfahren nach mindestens einem der Ansprüche 1 bis 8, **dadurch gekennzeichnet,** daß eine Komponente des Agens Aminogruppen als reaktive Gruppen aufweist.

10. Verfahren nach mindestens einem der Ansprüche 1 bis 9, **dadurch gekennzeichnet,** daß die UV-absorbierende Komponente und die vernetzende Komponente in einer zumindest bifunktionellen Verbindung realisiert sind.

11. Verfahren nach mindestens einem der Ansprüche 1-10, **dadurch gekennzeichnet,** daß ein Agens verwendet wird, welches zumindest eine Komponente enthält, die einer der allgemeinen Strukturformeln K,L oder H gehorcht.

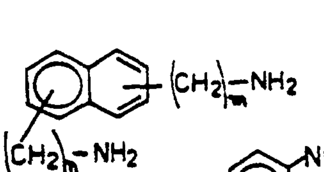

K

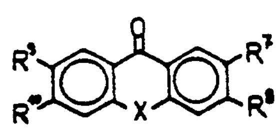

M

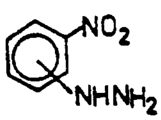

L

wobei m und m ganze Zahlen mit 0 m,n 10 darstellen, R7 und R8 für H oder elektronenziehende Gruppen wie Z.B. $-NO_2$ oder -COOR stehen, R9 und R10 $-(CH_2)$ - $NH_2$ bedeuten und X für -S-, -NH-, $-CH_2-$ oder -O- steht.

FIG 1

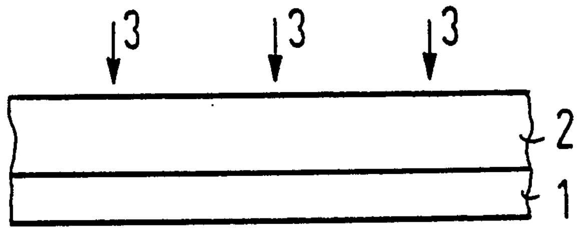


FIG 2

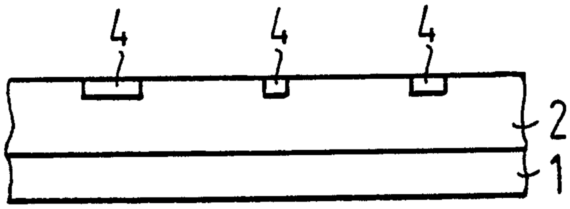


FIG 3

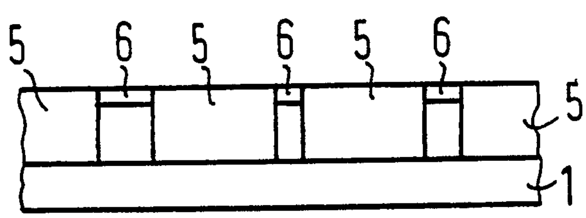


FIG 4